(19) Europäisches Patentamt / European Patent Office / Office européen des brevets

(11) **EP 3 422 390 B1**

(12) **FASCICULE DE BREVET EUROPEEN**

(45) Date de publication et mention de la délivrance du brevet:
**26.08.2020 Bulletin 2020/35**

(51) Int Cl.:
*H01L 21/285* (2006.01)  *H01L 29/417* (2006.01)
*H01L 29/45* (2006.01)

(21) Numéro de dépôt: **18180973.2**

(22) Date de dépôt: **29.06.2018**

(54) **PROCEDE DE REALISATION DE CONTACT INTERMETALLIQUE A BASE DE NI SUR INXGA1-XAS**

VERFAHREN ZUR HERSTELLUNG EINES INTERMETALLISCHEN KONTAKTS AUF DER BASIS VON NI AUF INXGA1-XAS

METHOD FOR PRODUCING NI-BASED INTERMETALLIC CONTACT ON INXGA1-XAS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **29.06.2017 FR 1756022**

(43) Date de publication de la demande:
**02.01.2019 Bulletin 2019/01**

(73) Titulaire: **Commissariat à l'Energie Atomique et aux Energies Alternatives
75015 Paris (FR)**

(72) Inventeurs:
• **RODRIGUEZ, Philippe**
  **38690 LE GRAND-LEMPS (FR)**
• **ZHIOU, Seifeddine**
  **2100 GAFSA (TN)**
• **NEMOUCHI, Fabrice**
  **38430 MOIRANS (FR)**
• **GERGAUD, Patrice**
  **38500 LA BUISSE (FR)**

(74) Mandataire: **Esselin, Sophie et al
Marks & Clerk France
Conseils en Propriété Industrielle
Immeuble Visium
22 avenue Aristide Briand
94117 Arcueil Cedex (FR)**

(56) Documents cités:
• ZHIOU SEIFEDDINE ET AL: "Reaction of Ni film with In0.53Ga0.47As: Phase formation and texture", JOURNAL OF APPLIED PHYSICS, AMERICAN INSTITUTE OF PHYSICS, US, vol. 120, no. 13, 4 octobre 2016 (2016-10-04), XP012212419, ISSN: 0021-8979, DOI: 10.1063/1.4963716 [extrait le 2016-10-04]
• RABHI S ET AL: "Phase formation between Ni thin films and GaAs substrate", SCRIPTA MATERIALIA, ELSEVIER, AMSTERDAM, NL, vol. 141, 22 juillet 2017 (2017-07-22), pages 28-31, XP085197586, ISSN: 1359-6462, DOI: 10.1016/J.SCRIPTAMAT.2017.07.011
• PERRIN C ET AL: "Formation of Ni3InGaAs phase in Ni/InGaAs contact at low temperature", APPLIED PHYSICS LETTERS, A I P PUBLISHING LLC, US, vol. 109, no. 13, 26 septembre 2016 (2016-09-26), XP012212253, ISSN: 0003-6951, DOI: 10.1063/1.4963132 [extrait le 2016-09-26]
• IVANA ET AL: "Crystal structure and epitaxial relationship of Ni4InGaAs2 films formed on InGaAs by annealing", JOURNAL OF VACUUM SCIENCE & TECHNOLOGY B: MICROELECTRONICS AND NANOMETER STRUCTURES, AMERICAN INSTITUTE OF PHYSICS, 2 HUNTINGTON QUADRANGLE, MELVILLE, NY 11747, vol. 31, no. 1, 1 janvier 2013 (2013-01-01), pages 12202-12202, XP012172447, ISSN: 2166-2746, DOI: 10.1116/1.4769266 [extrait le 2012-12-03]

**Description**

Le domaine de l'invention est celui des composants en matériaux III-V et plus précisément celui des composants $In_xGa_{1-x}As$ avec $0 \leq x \leq 1$, comprenant la réalisation de contacts intermétalliques.

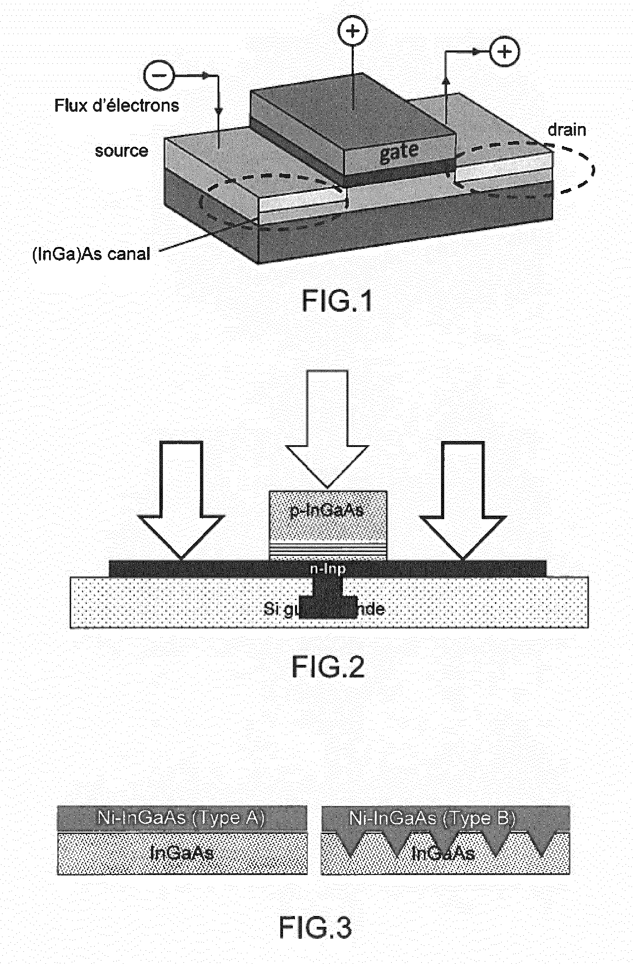

La figure 1 illustre ainsi un exemple de transistor comprenant un canal en $In_xGa_{1-x}As$ mettant en évidence la source, la grille et le drain, nécessitant la reprise de contacts. La figure 2 illustre un autre type de configuration pour des applications photoniques nécessitant également la reprise de contacts et dans lequel la présente invention peut être particulièrement d'intérêt.

Les contacts sur $In_xGa_{1-x}As$ avec $0 \leq x \leq 1$ compatibles avec une technologie Si-CMOS sont généralement réalisés par réaction à l'état solide entre un métal (Ni) ou un alliage métallique $Ni_yM_{1-y}$ et le semi-conducteur (InGaAs) comme décrit dans la publication de S. H. Kim et al., IEDM 2010, 26.6.

Cette réaction réalisée entre 200 et 500 °C par un recuit rapide sous atmosphère contrôlée conduit à l'obtention d'un composé intermétallique Ni-InGaAs, comme décrit dans la publication de Ivana et al., J. Vac. Sci. Technol., B 31 (2013) 012202 et dans la publication de P. Shekter et al., J. Vac. Sci. Technol., B 31 (2013) 031205, qui peut être utilisé pour la reprise de contacts des S/D du transistor comme décrit dans la publication de S. H. Kim et al., IEEE Trans. Electron. Devices 60 (2013) 2512 ou contacter l'électrode servant de pompage électrique du laser comme décrit dans la publication de E. Ghegin et al., IEEE Silicon Nanoelectronics Workshop 2016, 214.

Jusqu'à ce jour, la nature des phases et des textures obtenues lors de la réaction à l'état solide entre le Ni et InGaAs était mal connue comme décrit dans la publication de S. Zhiou et al., J. Appl. Phys. 120 (2016) 13530.

Il a déjà été publié également de la littérature concernant la réalisation d'intermétalliques sur substrat de GaAs ou de InGaAs, comme dans la publication de RABHI S et AL : « Phase formation between Ni thin films and GaAs substrate » SCRIPTA MATERIALIA, ELSEVIER, AMSTERDAM, NL, vol.141,22 juillet 2017 (2017-07-22), pages 28-31, XP08519586, ISSN : 1359-6462, DOI : 10.1016/ J.SCRIOTAMAT.2017.07.011 ou la publication de PERRIN C ET AL : « Formation of Ni3inGaAs phase in Ni/InGaAs contact at low temperature », APPLIED PHYSICS LETTERS, A I P PUBLISHING LLC,US, vol.109, n° 13, 26 septembre 2016 (2016-09-26), XP01331253, ISSN : 0003-6951, DOI : 10.1063/1.49633132

Or une maîtrise de ces dernières peut conduire à l'obtention d'un composé intermétallique optimisé, notamment en termes de stabilité morphologique, d'épaisseur et de résistivité de contact permettant une maîtrise de l'élaboration des contacts.

C'est pourquoi dans ce contexte, la présente invention a pour objet un procédé de fabrication de contact intermétallique optimisé.

Le Demandeur propose un procédé permettant de contrôler les phases et les textures du composé intermétallique Ni-InGaAs , basé sur une étude approfondie de la réaction à l'état solide entre le métal Ni et le composé $In_xGa_{1-x}As$ avec $0 \leq x \leq 1$ et ce afin de favoriser :

- une texture conduisant à une interface de contact et une morphologie optimisées ;
- une phase hexagonale à stœchiométrie bien définie favorable en termes de résistivité de contact.

L'intérêt de la présente invention réside dans le fait de réaliser un procédé d'obtention de composé intermétallique qui permette de rester en dessous de la barrière de nucléation de la texture non favorable tant que tout le Ni n'a pas été consommé.

Par rapport à l'état de l'art, la présente invention apporte une solution permettant de maîtriser de façon reproductible la morphologie des contacts au travers du contrôle de la texture et de la phase et donc de favoriser une plus faible résistivité.

La présente invention concerne un procédé permettant par une opération de recuit thermique calibré en fonction de l'épaisseur de nickel déposée, de ne former qu'un type de première texture souhaitée tout en évitant de former une seconde texture indésirable comme il sera explicité et développé dans la description détaillée de la présent demande. Plus précisément l'invention a pour objet un procédé de fabrication selon la revendication 1.

Avantageusement, la vitesse de montée en température est déterminée inférieure à une vitesse maximale $V_{max}$, ladite vitesse maximale dépendant de la cinétique de la texture qui se forme.

Avantageusement, la vitesse maximale de recuit (en °C / min) répond à l'équation suivante en fonction de l'épaisseur de Ni déposée (en nm) : $V_{max} = 12314.7x^{-1.91582}$

Avantageusement la fraction molaire x du substrat est comprise entre 0,25 et 0,80. Selon des variantes de l'invention, le procédé comprend un premier recuit à une première température durant une première durée pour former un premier composé intermétallique de première texture et présentant une première phase et un second recuit à une température plus élevée que ladite première température pour former un second composé intermétallique de première texture et présentant une seconde phase.

Le composé intermétallique Ni-InGaAs peut typiquement être un composé $Ni_2InGaAs$ ou un composé

Ni$_3$lnGaAs**.**

Selon des variantes de l'invention le procédé comprend un recuit effectué à une température comprise entre 200°C et 320°C, pour former la première texture A, avec une préférence pour la gamme 240°C et 290°C pendant une durée dépendante de l'épaisseur de Ni déposée, pour former un composé intermétallique de Ni$_3$lnGaAs.

Typiquement pour une épaisseur initiale de Ni comprise entre quelques nanomètres et quelques dizaines de nanomètres, la durée de recuit peut varier entre quelques minutes et quelques dizaines de minutes.

Selon des variantes de l'invention, ledit recuit effectué à une température comprise entre 200°C et 320°C, avec une préférence pour la gamme 240°C et 290°C est suivi d'un recuit effectué à une température comprise entre 250 °C et 550 °C pour modifier la résistivité dudit contact intermétallique formé.

Selon des variantes de l'invention, ledit recuit effectué à une température comprise entre 200°C et 320°C, avec une préférence pour la gamme 240°C et 290°C est suivi d'un recuit effectué à une température comprise entre 300 "C et 500 °C pour consolider la phase Ni$_3$lnGaAs (dans la fourchette basse) ou former la phase Ni$_2$lnGaAs (dans la fourchette haute).

Il est à noter que les 2 phases Ni$_3$lnGaAs et Ni InGaAs présentent la même structure avec des compositions variables selon le taux d'occupation des sites interstitiels, la phase Ni$_2$InGaAs étant la phase la plus stable à haute température (350 - 500 °C).

Selon des variantes de l'invention, les abaques sont élaborés en mesurant les épaisseurs de composé intermétallique formées en fonction du temps.

Selon des variantes de l'invention, les mesures d'épaisseur sont réalisées par réflectivité de rayons X.

Selon des variantes de l'invention, les mesures d'épaisseur sont réalisées par ellipsométrie.

Selon des variantes de l'invention, le procédé comprend le dépôt d'une couche protectrice à la surface du dépôt localisé de Ni, préalablement à(aux) l'opération(s) de recuit.

L'invention a aussi pour objet le contact intermétallique obtenu selon le procédé de l'invention.

L'invention a encore pour objet un procédé de fabrication d'un transistor comprenant le procédé de fabrication de contact intermétallique de l'invention.

L'invention a aussi pour objet un procédé de fabrication d'un composant photonique comprenant le procédé de fabrication de contact intermétallique de l'invention.

L'invention sera mieux comprise et d'autres avantages apparaîtront à la lecture de la description qui va suivre donnée à titre non limitatif et grâce aux figures parmi lesquelles :

- La figure 1 illustre un exemple de structure de transistor selon l'art connu pouvant comprendre des contacts intermétalliques ;
- La figure 2 illustre un exemple de structure photonique selon l'art connu pouvant comprendre des contacts intermétalliques ;
- la figure 3 schématise les deux textures du composé intermétallique Ni-InGaAs pouvant être obtenues lors d'une opération de recuit ;
- les figures 4a et 4b illustrent deux options de l'invention avec une rampe ou deux rampes de recuit, dans le cas d'un dépôt de Ni de 10 nm ;
- les figures 5a-5c illustrent l'apparition de la seconde texture au-delà de la température de nucléation de la seconde texture, en fonction de la vitesse de recuit pour une épaisseur de Ni de 7nm ;
- les figures 6a-6c illustrent l'apparition de la seconde texture au-delà de la température de nucléation de la seconde texture, en fonction de la vitesse de recuit pour une épaisseur de Ni de 10nm ;
- les figures 7a-7c illustrent l'apparition de la seconde texture au-delà de la température de nucléation de la seconde texture, en fonction de la vitesse de recuit pour une épaisseur de Ni de 20 nm ;
- les figures 8a-8c illustrent de manière générique les précédentes figures, en matérialisant par des zones hachurées, les zones à exclure (zone où la texture B est susceptible de se former) ;
- la figure 9 illustre la fonction que le Demandeur a établi fournissant cette vitesse maximale de recuit V$_{max}$ (en °C/min) en fonction de l'épaisseur de Ni (en nm);
- la figure 10 illustre les différentes phases de composés intermétalliques formés en fonction de la température dans le cas d'une réaction solide entre Ni et In$_x$Ga$_{1-x}$As ;
- la figure 11 illustre l'évolution du paramètre de maille du substrat In$_x$Ga$_{1-x}$As en fonction de la teneur en indium (x) ;
- la figure 12 illustre l'évolution du désaccord de maille pour les 2 textures de l'intermétallique Ni$_3$In$_{0.53}$Ga$_{0.47}$As en fonction de la teneur en indium du substrat ;
- la figure 13 illustre l'évolution de la résistance carrée de contact d'un exemple de couche formée de Ni-In$_{0.53}$Ga$_{0.47}$As en fonction de la température de recuit ;
- la figure 14 illustre l'évolution de la résistivité de contact d'un exemple de couche formée de Ni-In$_{0.53}$Ga$_{0.47}$As en fonction de la température de recuit.

De manière générale, lorsque l'on réalise un contact intermétallique à partir du dépôt de Ni à la surface d'une couche ou d'un substrat de $In_xGa_{1-x}As$, la réaction à l'état solide entre Ni et $In_xGa_{1-x}As$ conduit à l'obtention de plusieurs composés intermétalliques Ni-InGaAs présentant une structure cristallographique : hexagonale type B8. Comme certains composés intermétalliques, cette phase hexagonale présente 2 textures (A et B) qui se caractérisent par leurs orientations par rapport au substrat.

Pour la texture A, les plans $(10\bar{1}0)$ de l'intermétallique sont parallèles à la surface (lorsque cette dernière est orientée selon les plans (100)) de la couche ou du substrat de $In_xGa_{1-x}As$ tandis que pour la texture B ce sont les plans $(0001)$ qui sont parallèles aux plans (111) de ladite surface.

Cela conduit dans le premier cas à l'obtention d'un hexagone dont l'axe c est parfaitement parallèle à la surface de la couche ou du substrat (texture A) et donc une interface Ni-InGaAs / $In_xGa_{1-x}As$ parfaitement plane, et dans l'autre cas à un hexagone qui est orienté selon les plans (111) de la couche ou du substrat donnant une interface très rugueuse et pouvant entrainer des défauts électriques (percement de jonction, augmentation de résistivité de contact). Ceci est schématisé sur la figure 3.

Le Demandeur a mené des expériences permettant de démontrer que la texture du composé intermétallique peut être contrôlée par le budget thermique ou l'épaisseur de métal (si l'on est amené à fixer le budget thermique) mis en œuvre lors de la réaction à l'état solide entre le Ni et $In_xGa_{1-x}As$ et a conclu qu'il convient de consommer la totalité du Ni avant de dépasser la température de nucléation de la texture B. Cette température est comprise entre 200°C et 320°C, avec une préférence pour la gamme 240°C et 290°C selon la teneur en In dans $In_xGa_{1-x}As$.

La durée du recuit à appliquer pour consommer totalement le Ni dépend de la température du recuit et de l'épaisseur initiale de Ni déposé.

Selon la présente invention, il est proposé d'élaborer des abaques qui permettent de déterminer en fonction de l'épaisseur initiale de Ni et de la température du recuit, le temps nécessaire pour consommer tout le Ni.

Plus précisément, le Demandeur a mis en évidence l'influence de l'opération de recuit sur la formation de la texture souhaitée, sans former la texture indésirable, et ce en contrôlant la vitesse de montée en température pour atteindre la température désirée de recuit appelée température finale de recuit, et le maintien de cette température au cours d'un plateau et ce en fonction de l'épaisseur de nickel. Le Demandeur a étudié deux options de recuit possibles, respectivement relatives à :

- une étape de recuit présentant une rampe 1 en température et un plateau, correspondant à l'option la plus simple ;
- une étape de recuit présentant une rampe 1, suivie d'une rampe 2 et d'un plateau, correspondant à une option plus industrialisable.

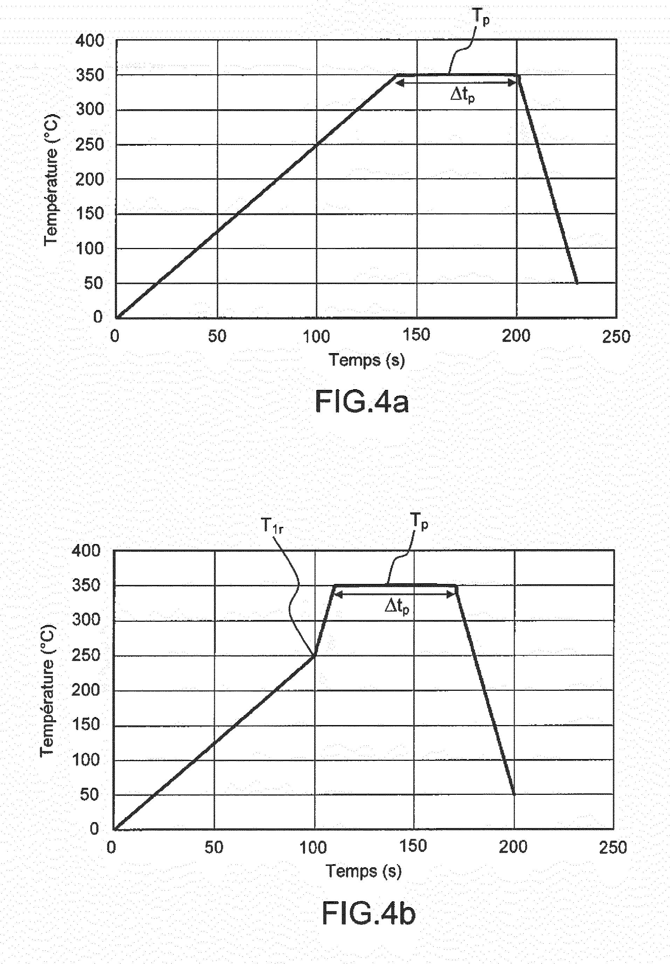

Les figures 4a et 4b illustrent ces deux options, dans le cas d'un dépôt de Ni de 10 nm.

La plage de température de plus basse résistance de contact est située entre 300°C et 350°C.

Il est nécessaire d'avoir obtenu une consommation totale de Ni dans la plage 200°C et 320°C, avec une préférence pour la gamme 240°C et 290°C pour éviter de former la seconde texture dite B.

Une méthode globale consiste à mesurer l'épaisseur de composé intermétallique formé (ou du Ni consommé) en fonction du temps pour différentes températures de recuit. Cette mesure d'épaisseur peut être réalisée par différentes méthodes de caractérisation : par une analyse par réflectivité de rayons X (couramment dénommée XRR, pour X-Ray Reflectivity), par ellipsométrie, microscopie, etc... ou toutes méthodes permettant d'extraire l'épaisseur du composé intermétallique et celle du Ni. L'épaisseur L de composé intermétallique formé est généralement proportionnelle au taux de formation D multiplié par le temps t, le tout à un facteur puissance n (n étant compris entre ½ et 4) comme défini ci-après :

$$L = (D.t)^n$$

Suivant la méthode décrite précédemment, on peut donc aisément déterminer des taux de formation pour différentes températures et par modélisation obtenir le temps nécessaire pour consommer totalement le nickel pour une épaisseur initiale et une température de recuit données.

Ainsi, suivant cette méthodologie et à partir de données recueillies dans la littérature, telles que décrites dans les publications de J. S. Solomon and S. R. Smith, J. Vac. Sci. Technol. A 5 (1987) 1809 et de H. F. Chuang et al., J. Electron. Mater. 24 (1995) 767,

Plus précisément, Chuang et al. mesurent des épaisseurs de GaAs consommé pour une température et différents temps, Solomon et Smith mesurent des gradients de concentration de Ni en fonction de la température pour un temps donné. Les deux en déduisent des coefficients de diffusion du Ni dans GaAs (ou taux de formation).

Le Demandeur a réalisé différentes études pour déterminer les paramètres permettant d'optimiser l'opération de recuit tout en ne formant que la première texture A, en évitant de former la seconde texture B.

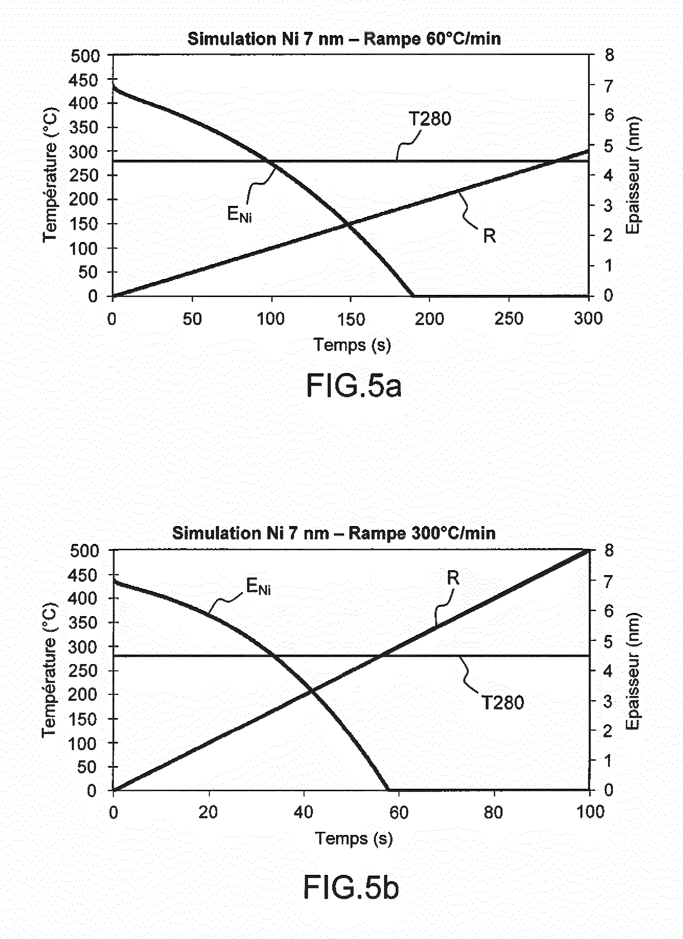

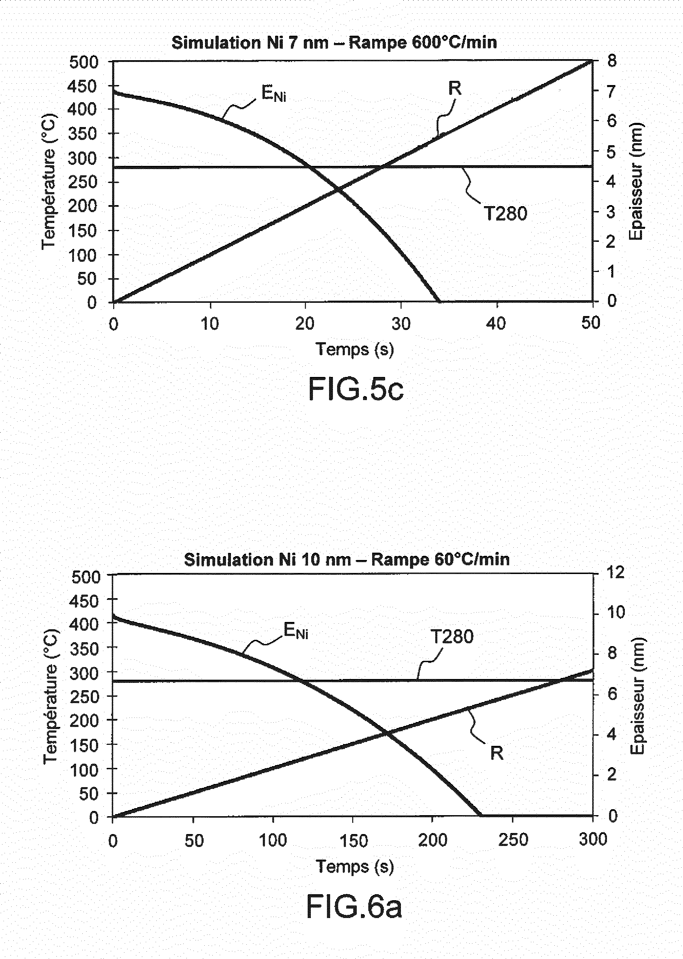

Les figures 5a-5c, 6a-6c, 7a-7c illustrent l'apparition de la seconde texture au-delà de la température de nucléation de la seconde texture, en fonction de la vitesse de recuit et en fonction de l'épaisseur de Ni déposée.

Plus précisément :

- les figures 5a-5c sont relatives à une épaisseur de Ni de 7nm ;
- les figures 6a-6c sont relatives à une épaisseur de Ni de 10nm ;

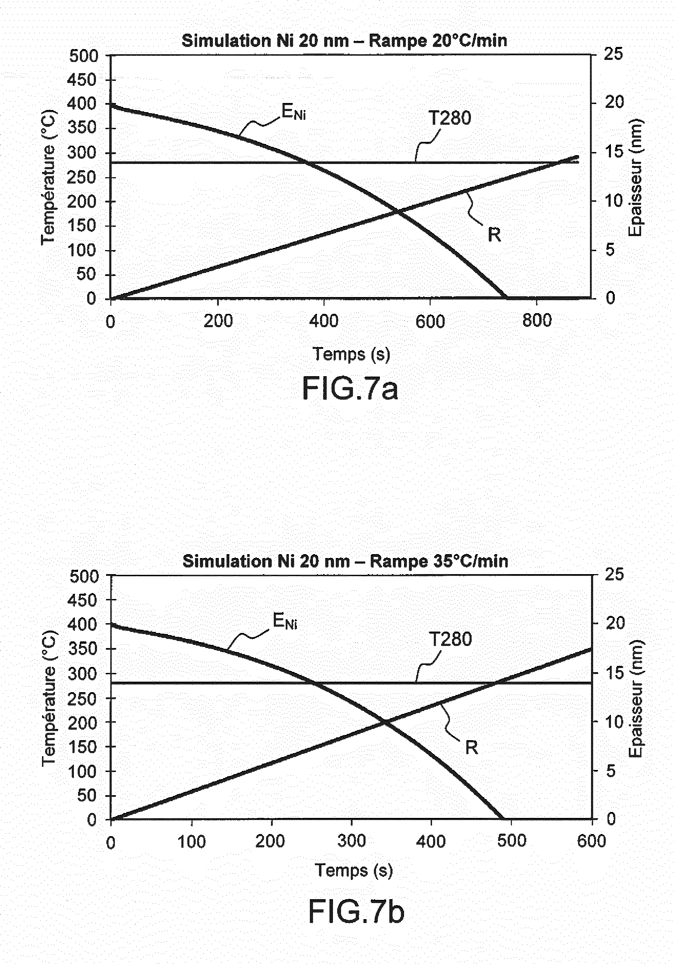

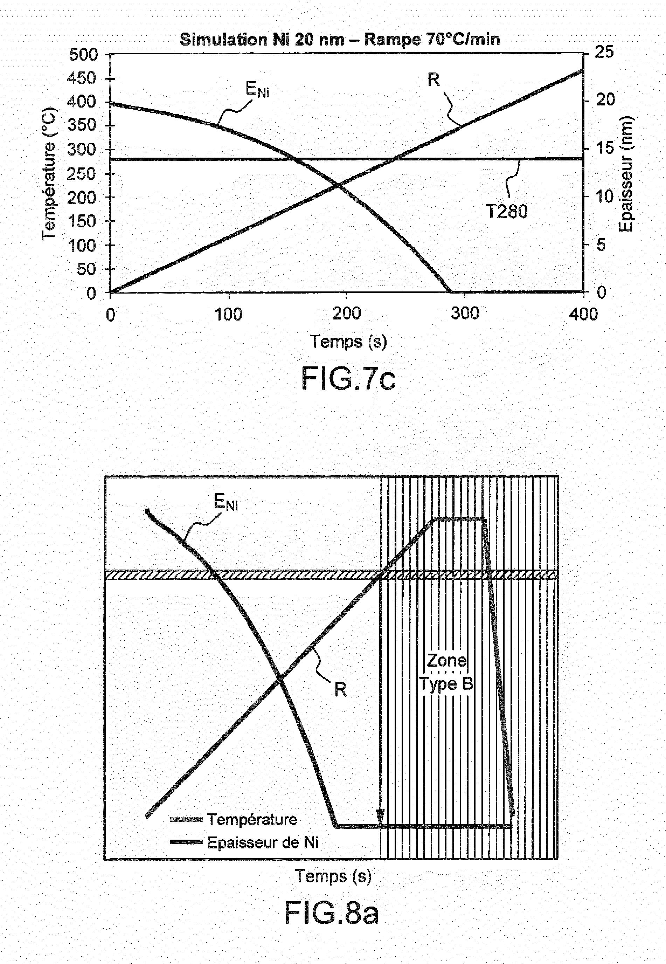

- les figures 7a-7c sont relatives à une épaisseur de Ni de 20 nm.

Les figures 8a-8c illustrent de manière générique les précédentes figures, en matérialisant par des zones hachurées, les zones à exclure (zone où la texture B est susceptible de se former si du nickel est présent). Plus précisément, les courbes $E_{Ni}$ sont relatives à l'épaisseur de Ni en fonction du temps, les droites R sont relatives aux rampes de température.

La bande hachurée grise horizontale correspond à la température de nucléation $T_{nucl}$ du type B de la seconde texture.

La zone hachurée correspond à la zone potentielle où le type de seconde texture B peut croitre si elle intercepte la courbe $E_{Ni}$ du Ni avant consommation complète.

La courbe représentant la rampe R doit couper la zone de nucléation (zone hachurée) une fois que tout le Ni est consommé (courbe $E_{Ni}$) afin de favoriser uniquement la formation de la première texture de type A.

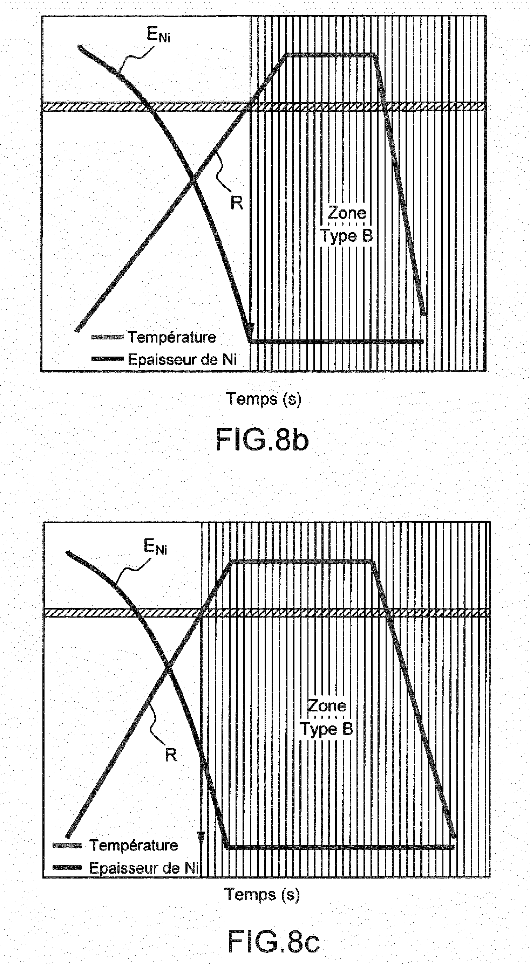

La figure 8a correspond à un cas 1 : avec une rampe lente et à la formation uniquement de la première texture La figure 8b correspond à un cas 2 : avec une rampe limite et encore la formation uniquement de la première texture.

La figure 8c correspond à un cas 3 : avec une rampe trop rapide et la formation de la première texture A et de la seconde texture B.

Le Demandeur a ainsi pu établir le Tableau ci-dessous liant les rampes limites (correspondant à une vitesse maximale de montée en température) en fonction de l'épaisseur.

| Epaisseur (nm) | Rampe limite (°C/min) |
|---|---|
| 5 | 550 |
| 6 | 417 |
| 7 | 300 |
| 8 | 225 |
| 9 | 185 |
| 10 | 150 |
| 11 | 124 |
| 12 | 105 |
| 13 | 88 |
| 15 | 66 |
| 17 | 52 |
| 20 | 35 |

Plus l'épaisseur est grande plus la rampe doit être faible et donc plus un temps de recuit long est nécessaire.

La fonction qui lie la rampe maximale (en °C/min) utilisable avec l'épaisseur de Ni déposée (en nm) est une fonction puissance :

$$y = 12314.7x^{-1.91582}$$

Les coefficients de cette fonction dépendent de la cinétique de la phase qui se forme.

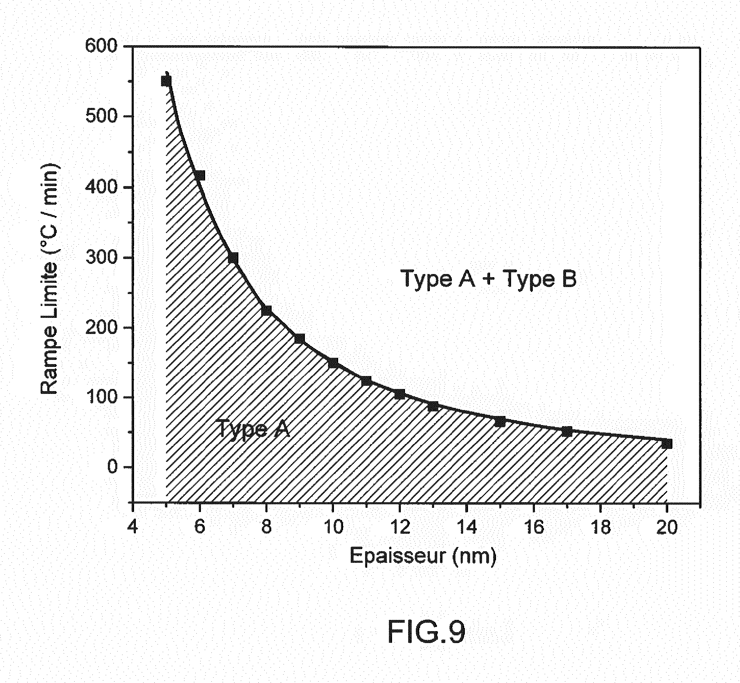

La figure 9 illustre la relation que le Demandeur a établi fournissant cette vitesse maximale $V_{max}$ (en °C/min) en fonction de l'épaisseur de Ni (en nm).

**Des exemples de rampes et de durées de plateaux sont fournis ci-après dans le cas d'une seule rampe**

Le Demandeur fournit des plages de durées, (il est indiqué que les temps totaux : rampe + plateau, n'intègrent pas les temps de refroidissement, la durée du plateau étant de 60 s). Le temps minimal correspond typiquement à la pente $V_{max}$ du cas limite .

Pour une épaisseur de 7 nm de Ni :

Temps minimal : 70 s
Vitesse de Rampe : 300°C/min
Temps total : 130 s

Pour une épaisseur de 10 nm de Ni :

Temps minimal : 140 s
Vitesse de Rampe : 150°C/min
Temps total : 200 s

Pour une épaisseur de 20 nm de Ni :

Temps minimal : 600 s
Vitesse de Rampe : 35°C/min
Temps total : 660 s

**Des exemples de rampes et de durées de plateaux sont fournis ci-après dans le cas de deux rampes :**

L'intérêt d'une double rampe réside dans le fait de réduire le temps total du cas minimal (pour une épaisseur donnée).

Pour une épaisseur de 7 nm de Ni :

Temps minimal : 56 s
Vitesse de Rampe R1 : 300°C/min
Durée de Rampe R2 : 10 s
Temps total : 126 s

Pour une épaisseur de 10 nm de Ni :

Temps minimal : 112 s
Vitesse de Rampe R1 : 150°C/min
Durée de Rampe R2 : 10 s
Temps total : 182 s

Pour une épaisseur de 20 nm de Ni :

Temps minimal : 480 s
Vitesse de Rampe R1 : 35°C/min
Durée de Rampe R2 : 10 s
Temps total : 550 s

le Demandeur fournit une estimation du temps de recuit nécessaire pour consommer totalement une couche de Ni à différentes températures de recuit (150, 200, 250 et 300 °C) pour le système Ni-GaAs (cas où x = 0). En effet, il existe une proportionnalité entre l'épaisseur de composé intermétallique et l'épaisseur initiale de Ni déposée.

Le Tableau 1 ci-dessous répertorie l'ensemble des résultats pour différentes épaisseurs initiales de Ni.

Tableau 1

| Température de recuit | Épaisseur de Ni initiale | | |
|---|---|---|---|
| | 5 nm | 10 nm | 50 nm |
| 150 °C | 2,8 min | 11,2 min | 277,4 min |
| 200 °C | 1,4 min | 5,8 min | 140,4 min |
| 250 °C | 0,8 min | 3,2 min | 75,6 min |
| 300 °C | 0,6 min | 1,8 min | 43,2 min |

Il est à noter que l'on trouve des taux de formation différents selon les publications qui peuvent s'expliquer par l'incertitude sur la mesure de l'épaisseur et l'incertitude sur la température de recuit.

Il donc nécessaire de réaliser ces abaques en tenant compte des équipements utilisés.

Il a par ailleurs, était reporté que la diffusion du Ni dans le composé GaAs ou celle du Ni dans le composé $In_{0.53}Ga_{0.47}As$ étaient très similaires dans l'article de Y. Ashizawa et al., J. Electron. Mater. 25 (1996) 715, c'est pourquoi, il est possible de considérer que les ordres de grandeur des données précédentes (reportées dans le Tableau 1) peuvent également être valables, de manière plus générale, pour le composé intermétallique générique de Ni-InGaAs.

Selon la présente invention, il est donc proposé d'établir des abaques définissant pour une épaisseur donnée de Ni, le couple de paramètres : température de recuit/temps de recuit pour consommer complètement une épaisseur donnée de Ni et d'appliquer ces couples de paramètres pour conduire à la formation d'un composé intermétallique de bonne texture, c'est-à-dire la première texture A présentant des propriétés optimales de surface de contact.

Selon le procédé de la présente invention, il est ainsi possible de contrôler la texture permettant de garantir le meilleur contact, la résistance de contact métal/semi-conducteur ($In_xGa_{1-x}As$ dans le cas présent) dépendant de la hauteur de barrière de Schottky et donc de la phase, donc de la stœchiométrie, en contact avec le semi-conducteur.

Le Demandeur a montré que dans le système considéré plusieurs phases peuvent se former : $Ni_3InGaAs$, $Ni_2InGaAs$, NiAs.

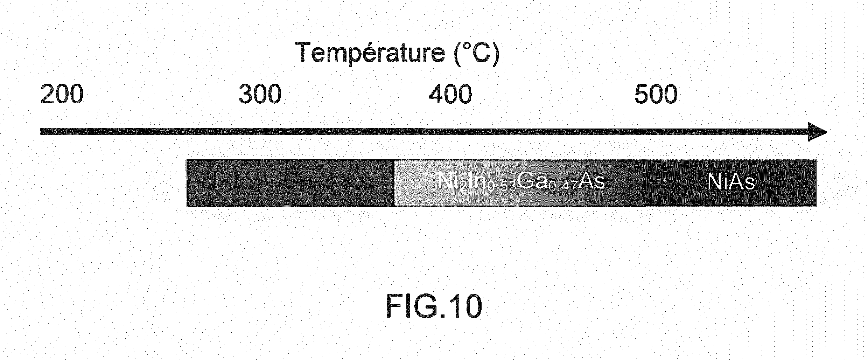

Le Demandeur s'est intéressé à la première phase et la texture A. L'obtention de la texture A se fait avec un faible budget thermique et la phase $Ni_3InGaAs$ nécessite un recuit dont la température est inférieure à 350 °C. La figure 10 illustre à cet effet, l'évolution de la formation des différentes phases pouvant être obtenues lors des réactions solides en présence de Ni et de $In_{0.53}Ga_{0.47}As$, encore appelée séquence de phases.

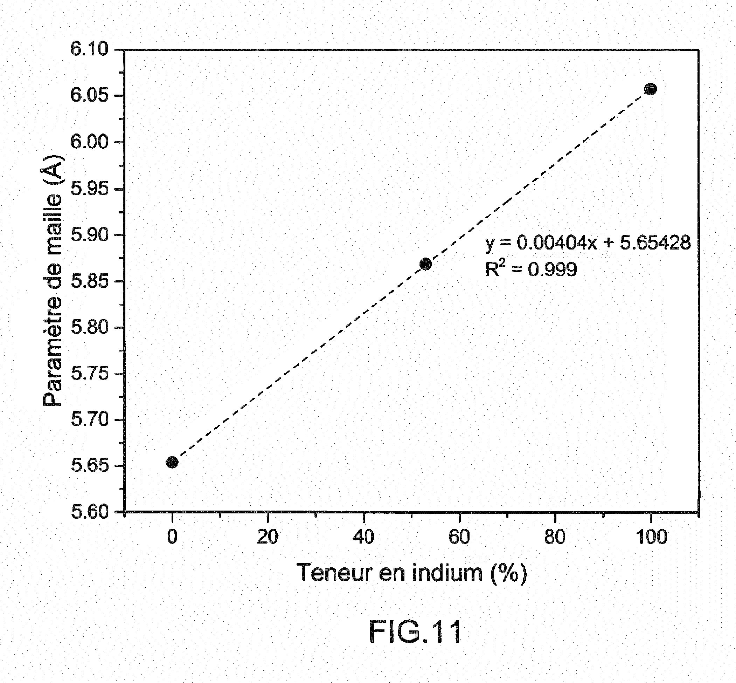

Le Demandeur a également analysé l'évolution du paramètre de maille du substrat $In_xGa_{1-x}As$ en fonction de la teneur en indium (x) reportée en figure 11 afin d'estimer une gamme de fractions molaires privilégiées au niveau de la composition du substrat pour laquelle la présente invention est particulièrement adaptée.

Cette évolution est basée sur l'application de la loi de Vegard entre les 2 cas extrêmes GaAs et InAs ainsi que la composition intermédiaire $In_{0.53}Ga_{0.47}As$.

A l'aide de l'équation de droite extraite de la figure A, le paramètre de maille du substrat $In_xGa_{1-x}As$ a pu être calculé pour x variant de 0 à 100 puis la distance interréticulaire entre les plans (110) et (111) a été calculée selon la formule usuelle pour une maille cubique :

$$\frac{1}{d^2} = \frac{h^2+k^2+l^2}{a^2}.$$

Les résultats sont reportés dans le tableau A qui fournit la valeur des distances interréticulaires pour les plans (110) et (111) du substrat $In_xGa_{1-x}As$ en fonction de la teneur en indium (x).

| %In | a | d(110) | d(111) |
|---|---|---|---|
| 0 | 5.6543 | 3.9981 | 3.2645 |
| 5 | 5.6743 | 4.0123 | 3.2760 |
| 10 | 5.6943 | 4.0264 | 3.2876 |
| 15 | 5.7143 | 4.0406 | 3.2991 |
| 20 | 5.7343 | 4.0547 | 3.3106 |
| 25 | 5.7543 | 4.0689 | 3.3222 |
| 30 | 5.7743 | 4.0830 | 3.3337 |
| 35 | 5.7943 | 4.0971 | 3.3453 |
| 40 | 5.8143 | 4.1113 | 3.3568 |
| 45 | 5.8343 | 4.1254 | 3.3684 |
| 50 | 5.8543 | 4.1396 | 3.3799 |
| 55 | 5.8743 | 4.1537 | 3.3915 |
| 60 | 5.8943 | 4.1678 | 3.4030 |
| 65 | 5.9143 | 4.1820 | 3.4146 |
| 70 | 5.9343 | 4.1961 | 3.4261 |
| 75 | 5.9543 | 4.2103 | 3.4377 |
| 80 | 5.9743 | 4.2244 | 3.4492 |
| 85 | 5.9943 | 4.2386 | 3.4608 |
| 90 | 6.0143 | 4.2527 | 3.4723 |
| 95 | 6.0343 | 4.2668 | 3.4839 |
| 100 | 6.0543 | 4.2810 | 3.4954 |

Tableau A

L'intermétallique de référence $Ni_3In_{0.53}Ga_{0.47}As$ / $In_{0.53}Ga_{0.47}As$ présente les paramètres de maille (maille hexagonale) suivants : a = 3.87 et c = 5.03. A partir de ces paramètres, on peut calculer les distances interréticulaires pour les plans $(10\bar{1}0)$ et (0001) de l'intermétallique qui correspondent respectivement aux textures A et B : 3.3515 Å et 5.03 Å.

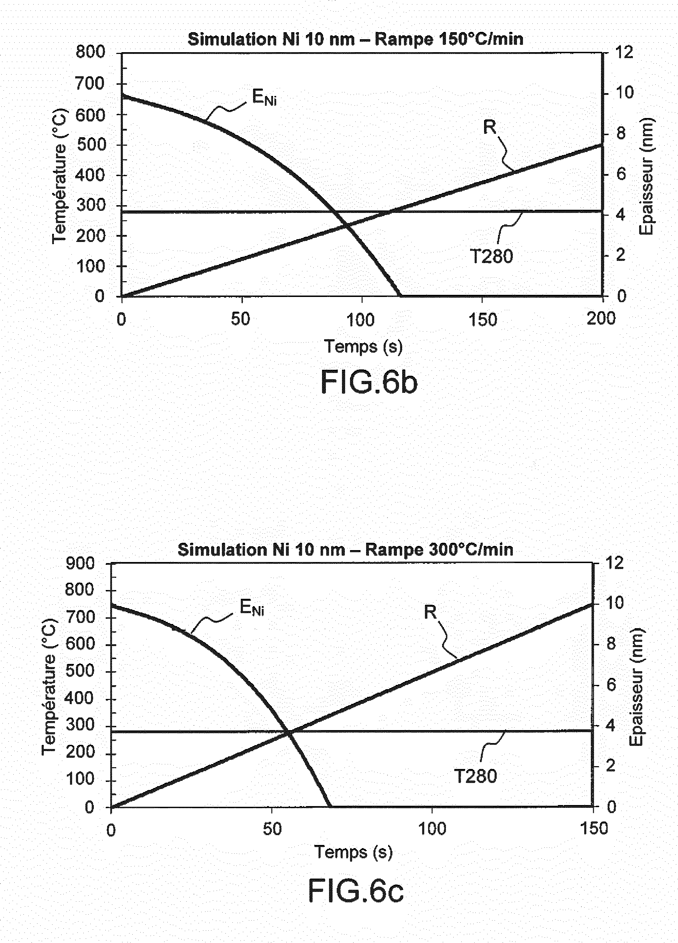

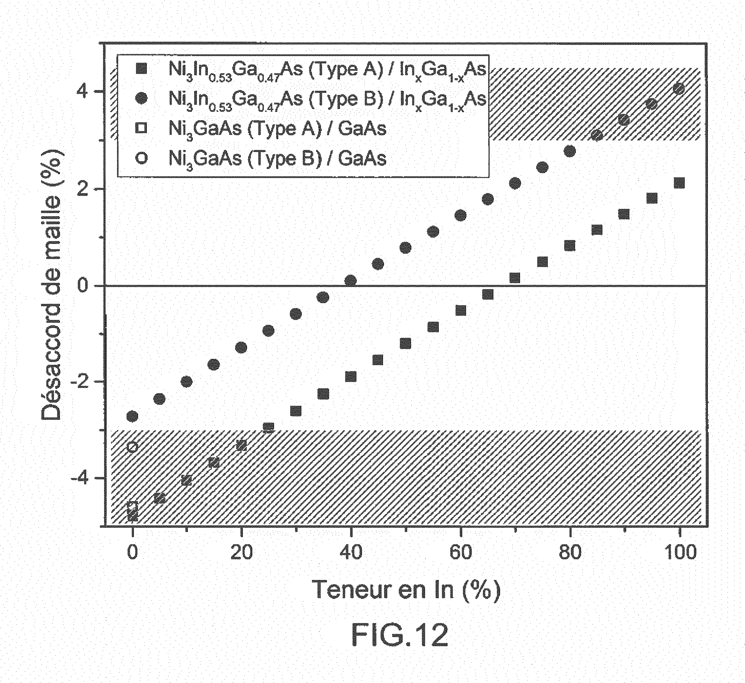

Pour cet intermétallique de référence, on peut calculer le désaccord de maille pour chacune des deux textures en fonction de la teneur en indium du substrat. Ceci est illustré par la figure 12. Le désaccord de maille pour la texture A est calculé par rapport au plan (110) du substrat. Quant au désaccord de maille de la texture B, il est calculé par rapport au plan (111) du substrat. Plus la valeur absolue du désaccord de maille est importante, plus la probabilité de former telle ou telle texture diminue. En effet, l'augmentation du désaccord de maille entraine une augmentation de la différence d'énergie entre l'intermétallique et le substrat. Deux zones grisées définies sur la figure 6 représentent des domaines où la probabilité pour que la texture concernée existe soit faible. Ainsi, en dessous de 25 % de teneur en indium, la probabilité de former la texture A est plus faible et au-delà de 80 % de teneur en indium, c'est la formation de la texture B qui est la moins favorable. Cette figure est construite à partir d'une approximation : c'est l'intermétallique de référence $Ni_3In_{0.3}Ga_{0.47}As$ qui est utilisé pour évaluer le désaccord de maille quelle que soit la teneur en indium. Or la stœchiométrie de l'intermétallique évolue en fonction de la teneur en indium du substrat (par exemple, on forme l'intermétallique $Ni_3In_{0.7}Ga_{0.3}As$ sur un substrat contenant 70 % d'indium). Afin de vérifier que cette approximation est valable, deux autres points ont été ajoutés à la figure 12, il s'agit des valeurs de désaccord de maille pour l'intermétallique $Ni_3GaAs$ sur GaAs. Les valeurs obtenues sont relativement proches et en tout cas concordantes avec celles obtenues pour l'intermétallique $Ni_3In_{0.53}Ga_{0.47}As$. Ainsi, malgré l'approximation réalisée, les « bornes » de coexistence des deux textures (25 % < x < 80 %) apparaissent préférentielles.

Exemple de procédé de l'invention comprenant la réalisation d'un contact intermétallique formé à partir de Ni sur un substrat de $In_{0.53}Ga_{0.47}As$ :

Le procédé comprend les étapes suivantes :

- Une étape de nettoyage du substrat ;
- Une étape de dépôt métallique de Ni ;
- Une ou plusieurs étape(s) de recuit permettant la formation de composé intermétallique avec la texture A à basse température et en consommant tout le Ni présent.

Etape de nettoyage :

Une surface de substrat de $In_{0.53}Ga_{0.47}As$ est traitée par une solution d'$HCl:H_2O$ (1:10 à 1:2, préférentiellement 1:10) pendant 45 à 60 s afin de retirer les oxydes natifs ($In_2O_3$, $Ga_2O_3$, $As_2O_3$, $As_2O_5$...). La couche semi-conductrice de $In_{0.53}Ga_{0.47}As$ est ensuite traitée dans une chambre de nettoyage in situ (dénommé couramment « preclean ») par un plasma Ar ou He afin de retirer les éventuels oxydes qui auraient recrû entre le traitement en phase liquide (dénommé couramment « WET ») et la mise sous vide des échantillons avant dépôt du métal.

Etape de dépôt métallique :

Sans remise à l'air de l'échantillon, un dépôt de Ni (7 à 80 nm) est réalisé sur la couche d'$In_{0.53}Ga_{0.47}As$. On peut avantageusement déposer une couche protectrice pouvant être de TiN (7 nm ou plus) afin de préserver l'échantillon d'une éventuelle oxydation à la surface du métal ou à l'interface métal / semi-conducteur.

Etape(s) de recuit :

L'ensemble couche métallique/substrat semi-conducteur est traité lors d'une étape de recuit sous atmosphère contrôlée. C'est le déroulement de cette étape de recuit qui est primordial pour contrôler la texture et la phase de l'intermétallique qui sera formé.

Le demandeur a montré que le composé intermétallique présentant les meilleures performances (rugosité d'interface et résistivité de contact) peut être obtenu grâce à un procédé en une étape ou en deux étapes (avec ou sans consommation complète du Ni). Dans le cas de 2 étapes sans consommation complète du Ni : une étape de retrait sélectif est indispensable.

La première étape (recuit basse température) permet de contrôler la texture de l'intermétallique et donc la morphologie de l'interface.

Une seconde étape de recuit haute température permet de faire éventuellement évoluer la phase formée lors de la première étape vers la phase la moins résistive sans modifier sa texture (et donc la morphologie d'interface).

Plus précisément, le Demandeur a montré que pour favoriser la texture qui fera croître le composé intermétallique de façon parallèle au substrat (en opposition avec la texture qui conduit à l'obtention d'un matériau pyramidal) il fallait chauffer l'échantillon à basse température (200°C et 320°C, avec une préférence pour la gamme 240°C et 290°C) pendant un temps suffisamment long pour permettre la diffusion et la consommation totale du Ni (ce temps dépend de l'épaisseur de la couche de Ni initiale, il peut varier de quelques minutes pour une couche de 7 nm à quelques dizaines de minutes pour une couche de 80 nm). La phase $Ni_3InGaAs$ est obtenue lors de ce recuit.

Une fois que le film de Ni est totalement consommé, un second recuit de type RTA (Rapid Thermal Annealing) peut être opéré afin de contrôler la phase du composé intermétallique : $250 \leq RTA < 350$ °C pour l'obtention de la phase $Ni_3In_{0.53}Ga_{0.47}As$ ou $350 \leq RTA < 500$ °C pour l'obtention de la phase $Ni_2In_{0.53}Ga_{0.47}As$. D'un point de vue résistivité de contact, la phase $Ni_3In_{0.53}Ga_{0.47}As$ semble néanmoins la plus favorable. Au-delà de 500 °C, on observe un rejet des atomes de Ga et d'In qui conduit à l'obtention de clusters d'InAs clairement non favorables en termes de résistivité de contact.

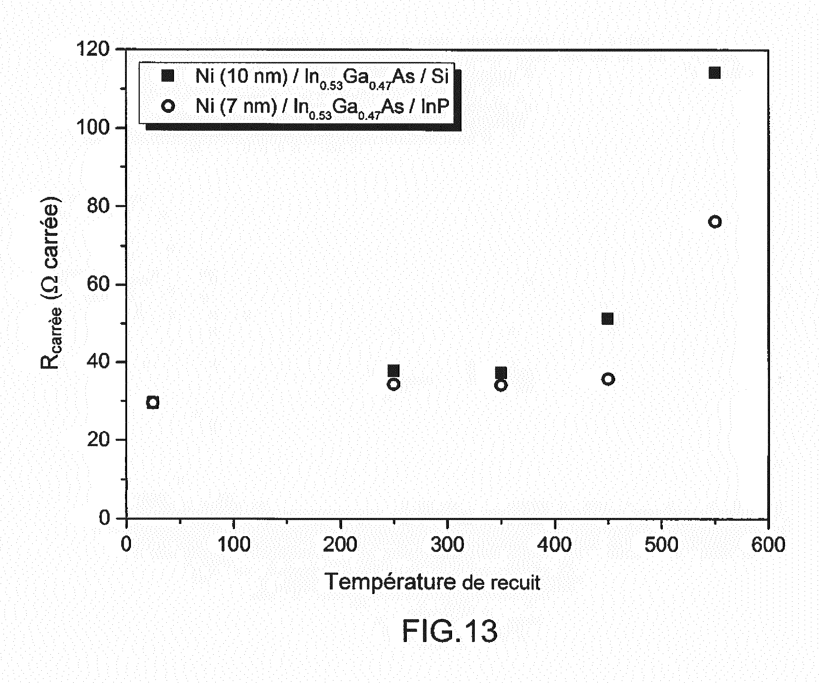

La figure 13 montre les résultats de mesure de résistances carrées de contact en fonction de la température de recuit pour :

- un dépôt métallique de Ni d'épaisseur initiale de 10 nm sur un empilement $In_{0.53}Ga_{0.47}As$ sur Si ;
- un dépôt métallique de Ni d'épaisseur initiale de 7 nm sur un empilement de $In_{0.53}Ga_{0.47}As$ sur InP.

Il apparait que les résistances carrées obtenues sont effectivement plus faibles jusqu'à des températures de recuit inférieures à 500 °C, avantageusement inférieures à 450°C.

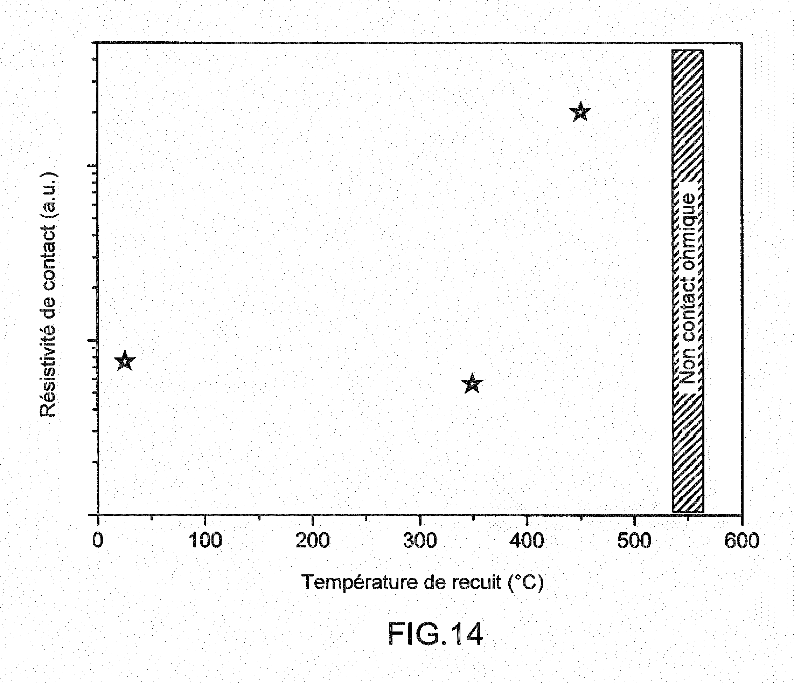

La figure 14 montre les résultats obtenus pour la résistivité de contact dans le cadre de Ni (20 nm) sur empilement $In_{0.53}Ga_{0.47}As$ / InP. Il apparait également que la résistivité de contact est suffisamment faible avec des composés obtenus avec des températures de recuit inférieures à 500 °C, avantageusement inférieures à 450 °C.

**Revendications**

1. Procédé de fabrication de contact intermétallique à la surface d'une couche ou d'un substrat de matériau $In_xGa_{1-x}As$ orientée (100) avec $0 \leq x \leq 1$, ledit contact comprenant un composé intermétallique de Ni-InGaAs ledit composé intermétallique ayant une structure cristallographique hexagonale pouvant présenter :

   - une première texture dont des plans ($10\overline{1}0$) du composé intermétallique sont parallèles à la surface de ladite couche ou dudit substrat et formée à une première température de nucléation ou
   - une seconde texture dont les plans ($0001$) du composé intermétallique sont parallèles aux plans (111) de ladite couche ou dudit substrat et formée à une seconde température de nucléation supérieure à ladite première température de nucléation ;

   ledit procédé comprenant les étapes suivantes :

   - l'élaboration d'abaques définissant pour une épaisseur de Ni déposé sur ledit matériau $In_xGa_{1-x}As$, le temps nécessaire pour consommer totalement l'épaisseur initiale de Ni déposé sur ledit matériau $In_xGa_{1-x}As$ en fonction de la température de recuit, ladite température de recuit étant inférieure à ladite température de nucléation de ladite seconde texture ;
   - le dépôt localisé de Ni à la surface dudit matériau $In_xGa_{1-x}As$ pour former une couche de Ni présentant une épaisseur de contact ;
   - une étape de recuit appliquant le couple de paramètres : temps nécessaire/ température de recuit, déduit desdites abaques en corrélation avec ladite épaisseur de contact de manière à former par réaction à l'état solide une couche de composé intermétallique de première texture, ladite étape de recuit comprenant :
   - une première étape de montée en température avec une première vitesse de montée en température permettant d'atteindre une première température de recuit ($T_{1r}$) ;
   - une deuxième étape de montée en température avec une deuxième vitesse de montée en température permettant d'atteindre depuis ladite première température de recuit, une température finale de recuit ($T_p$) ;
   - au moins un plateau de maintien en température de ladite température finale de recuit ($T_p$) pendant une durée de plateau ($\Delta t_p$).

2. Procédé de fabrication de contact intermétallique selon la revendication 1, dans lequel la vitesse de montée en température est déterminée inférieure à une vitesse maximale $V_{max}$ (en °C/min), ladite vitesse maximale étant définie par la fonction suivante en fonction de l'épaisseur x (en nm) de Ni déposé :

$$V_{max} = 12314.7x^{-1.91582}$$

3. Procédé de fabrication de contact intermétallique selon l'une des revendications 1 ou 2, dans lequel la fraction molaire x du substrat est comprise entre 0,25 et 0,80.

4. Procédé de fabrication de contact intermétallique selon l'une des revendications 1 à 3, comprenant une premier recuit à une première température durant une première durée pour former un premier composé intermétallique de première texture et présentant une première phase et un second recuit à une température plus élevée que ladite première température pour former un second composé intermétallique de première texture et présentant une seconde phase.

5. Procédé de fabrication de contact intermétallique selon l'une des revendications 1 à 4, comportant un recuit effectué à une température comprise entre 200°C et 320°C, avec une préférence pour la gamme 240°C et 290°C, pendant une durée dépendante de l'épaisseur de Ni déposée, pour former un composé intermétallique de $Ni_3InGaAs$.

6. Procédé de fabrication de contact intermétallique selon la revendication 5, dans lequel l'épaisseur initiale de Ni est comprise entre quelques nanomètres et quelques dizaines de nanomètres, la durée de recuit varie entre quelques minutes et quelques dizaines de minutes.

7. Procédé de fabrication selon l'une des revendications 5 ou 6, lequel ledit recuit effectué à une température comprise entre 200°C et 320°C, avec une préférence pour la gamme 240°C et 290°C est suivi d'un recuit effectué à une température comprise entre 250 °C et 550 °C pour modifier la résistivité dudit contact intermétallique formé.

**8.** Procédé selon l'une des revendications 6 ou 7, dans lequel ledit recuit effectué à une température comprise entre 200°C et 320°C, avec une préférence pour la gamme 240°C et 290°C est suivi d'un recuit effectué à une température comprise entre 250°C et 350°C pour former un composé de $Ni_3InGaAs$.

**9.** Procédé de fabrication de contact intermétallique selon l'une des revendications 1 à 8, dans lequel les abaques sont élaborés en mesurant les épaisseurs de composé intermétallique formées en fonction du temps.

**10.** Procédé de fabrication de contact intermétallique selon la revendication 9, dans lequel les mesures d'épaisseur sont réalisées par rayons X.

**11.** Procédé de fabrication de contact intermétallique selon la revendication 9, dans lequel les mesures d'épaisseur sont réalisées pas ellipsométrie.

**12.** Procédé de fabrication de contact intermétallique selon l'une des revendications 1 à 11, comprenant le dépôt d'une couche protectrice à la surface du dépôt localisé de Ni, préalablement à(aux) l'opération(s) de recuit.

**13.** Procédé de fabrication d'un transistor comprenant le procédé de fabrication de contact intermétallique selon l'une des revendications 1 à 12.

**14.** Procédé de fabrication d'un composant photonique comprenant le procédé de fabrication de contact intermétallique selon l'une des revendications 1 à 12.

**Patentansprüche**

**1.** Verfahren zur Herstellung eines intermetallischen Kontakts an der Oberfläche einer Schicht oder eines Substrates aus ausgerichtetem $In_xGa_{1-x}As$-Material (100), wobei $0 \leq x \leq 1$, wobei der Kontakt eine intermetallischen Verbindung aus Ni-InGaAs beinhaltet, wobei die intermetallischen Verbindung eine hexagonale kristallgeografische Struktur besitzt, welche Folgendes aufweisen kann:

- eine erste Struktur, bei welcher Ebenen (**$10\bar{1}0$**) der intermetallischen Verbindung parallel zur Oberfläche der Schicht oder des Substrates sind und die bei einer ersten Keimbildungstemperatur gebildet wird, oder
- eine zweite Struktur, bei welcher die Ebenen (**0001**) der intermetallischen Verbindung parallel zu den Ebenen (111) der Oberfläche der Schicht oder des Substrates sind und die bei einer zweiten Keimbildungstemperatur gebildet wird, welche die erste Keimbildungstemperatur überschreitet;

wobei das Verfahren folgende Schritte umfasst:

- Erstellen von Nomogramme, welche für eine auf dem $In_xGa_{1-x}As$-Material abgelagerte Ni-Dicke die Zeit, welche zum vollständigen Verbrauch der anfänglichen auf dem $In_xGa_{1-x}As$-Material abgelagerten Ni-Dicke notwendig ist, als eine Funktion der Glühtemperatur definieren, wobei die Glühtemperatur die Keimbildungstemperatur der zweiten Struktur unterschreitet;
- die lokalisierte Ni-Ablagerung an der Oberfläche des $In_xGa_{1-x}As$-Materials zum Bilden der Ni-Schicht, welche eine Kontaktdicke aufweist;
- einen Glühschritt, welcher das Parameterpaar: notwendige Zeit/Glühtemperatur anwendet, welches aus den Nonogrammen in Korrelation mit der Kontaktdicke in einer Weise abgeleitet wird, dass in Reaktion auf den festen Zustand eine Schicht aus intermetallischer Verbindung der ersten Struktur gebildet wird, wobei der Glühschritt Folgendes umfasst:
- einen ersten Schritt des Temperaturanstiegs mit einer ersten Temperaturanstiegsgeschwindigkeit, welche es ermöglicht, eine erste Glühtemperatur ($T_{1r}$) zu erreichen;
- einen zweiten Schritt des Temperaturanstiegs mit einer zweiten Temperaturanstiegsgeschwindigkeit, welche es ermöglicht, von der ersten Glühtemperatur eine finale Glühtemperatur ($T_p$) zu erreichen;
- mindestens ein Temperaturhalteplateau der finalen Glühtemperatur ($T_p$) über eine Plateaudauer ($\Delta t_p$).

**2.** Verfahren zur Herstellung eines intermetallischen Kontakts nach Anspruch 1, wobei die Temperaturanstiegsgeschwindigkeit unter einer maximalen Geschwindigkeit $V_{max}$ (in °C/min) festgelegt wird, wobei die maximale Geschwindigkeit anhand folgender Funktion angesichts der Dicke x (in nm) des abgelagerten Ni definiert wird:

$$V_{max} = 12314{,}7X^{-1{,}91582}$$

**3.** Verfahren zur Herstellung eines intermetallischen Kontakts nach einem der Ansprüche 1 oder 2, wobei der Molanteil x des Substrates zwischen 0,25 und 0,80 liegt.

**4.** Verfahren zur Herstellung eines intermetallischen Kontakts nach einem der Ansprüche 1 bis 3, umfassend ein erstes Glühen bei einer ersten Temperatur über eine erste Dauer zum Bilden einer ersten intermetallischen Verbindung erster Struktur und welche eine erste Phase aufweist, und ein zweites Glühen bei einer höheren Temperatur als die erste Temperatur, zum Bilden einer zweiten intermetallischen Verbindung erster Struktur und welche eine zweite Phase aufweist.

**5.** Verfahren zur Herstellung eines intermetallischen Kontakts nach einem der Ansprüche 1 bis 4, beinhaltend ein Glühen, welches bei einer Temperatur zwischen 200°C und 320°C durchgeführt wird, mit einem bevorzugten Bereich 240°C und 290°C, während einer Dauer, welche von der abgelagerten Ni-Dicke abhängt, um eine intermetallische Ni$_3$InGaAs-Verbindung zu bilden.

**6.** Verfahren zur Herstellung eines intermetallischen Kontakts nach Anspruch 5, wobei die anfängliche Ni-Dicke zwischen einigen Nanometern und einigen Zehn Nanometern liegt und die Glühdauer zwischen einigen Minuten und einigen Zehn Minuten variiert.

**7.** Herstellungsverfahren nach einem der Ansprüche 5 oder 6, wobei das bei einer Temperatur zwischen 200°C und 320°C erfolgte Glühen, mit einem bevorzugten Bereich 240°C und 290°C, von einem Glühen gefolgt ist, welches bei einer Temperatur zwischen 250 °C und 550 °C erfolgt, um den Widerstand des gebildeten intermetallischen Kontakts zu modifizieren.

**8.** Verfahren nach einem der Ansprüche 6 oder 7, wobei das bei einer Temperatur zwischen 200°C und 320°C erfolgte Glühen, mit einem bevorzugten Bereich 240°C und 290°C, von einem Glühen gefolgt ist, welches bei einer Temperatur zwischen 250°C und 350°C erfolgt, um eine Ni$_3$InGaAs-Verbindung zu bilden.

**9.** Verfahren zur Herstellung eines intermetallischen Kontakts nach einem der Ansprüche 1 bis 8, wobei die Tabellen durch Messen der Dicken der zeitabhängig gebildeten intermetallischen Verbindung erstellt werden.

**10.** Verfahren zur Herstellung eines intermetallischen Kontakts nach Anspruch 9, wobei die Dickenmessungen mittels Röntgenstrahlen erfolgen.

**11.** Verfahren zur Herstellung eines intermetallischen Kontakts nach Anspruch 9, wobei die Dickenmessungen mittels Ellipsometrie erfolgen.

**12.** Verfahren zur Herstellung eines intermetallischen Kontakts nach einem der Ansprüche 1 bis 11, umfassend die Ablagerung einer Schutzschicht an der Oberfläche der lokalisierten Ni-Ablagerung vor dem bzw. den Glühschritt(en).

**13.** Verfahren zur Herstellung eines Transistors, umfassend das Verfahren zur Herstellung eines intermetallischen Kontakts nach einem der Ansprüche 1 bis 12.

**14.** Verfahren zur Herstellung eines photonischen Bauteils, umfassend das Verfahren zur Herstellung eines intermetallischen Kontakts nach einem der Ansprüche 1 bis 12.

**Claims**

**1.** Process for manufacturing an intermetallic contact on the surface of a layer or of a substrate of oriented In$_x$Ga$_{1-x}$As material (100) with $0 \le x \le 1$, said contact comprising an Ni-InGaAs intermetallic compound, said intermetallic compound having a hexagonal crystallographic structure that may have:

- a first texture, of which ($10\bar{1}0$) planes of the intermetallic compound are parallel to the surface of said layer or of said substrate, and which is formed at a first nucleation temperature or
- a second texture, of which the (**0001**) planes of the intermetallic compound are parallel to the (111) planes of said layer or of said substrate, and which is formed at a second nucleation temperature above said first nucleation temperature;

said process comprising the following steps:

- the production of nomograms defining, for a thickness of Ni deposited on said $In_xGa_{1-x}As$ material, the time required to completely consume the initial thickness of Ni deposited on said $In_xGa_{1-x}As$ material as a function of the annealing temperature, said annealing temperature being below said nucleation temperature of said second texture;
- the localized deposition of Ni on the surface of said $In_xGa_{1-x}As$ material in order to form a layer of Ni having a contact thickness;
- an annealing step applying the pair of parameters: time required/annealing temperature, deduced from said nomograms in correlation with said contact thickness so as to form, by solid-state reaction, a layer of intermetallic compound of first texture, said annealing step comprising:
- a first temperature rise step with a first temperature rise rate that makes it possible to reach a final annealing temperature ($T_{1r}$) and
- a second temperature rise step with a second temperature rise rate that makes it possible to reach a final annealing temperature ($T_p$) from said first annealing temperature;
- at least one hold of said final annealing temperature ($T_p$), for a hold time ($\Delta t_p$).

2. Process for manufacturing an intermetallic contact according to claim 1, wherein the temperature rise rate is determined as being below a maximum rate $V_{max}$ (in °C/min), said maximum rate being defined by the following function as a function of the thickness x (in nm) of Ni deposited:

$$V_{max} = 12314.7x^{-1.91582}$$

3. Process for manufacturing an intermetallic contact according to one of claims 1 or 2, wherein the molar fraction x of the substrate is between 0.25 and 0.80.

4. Process for manufacturing an intermetallic contact according to one of claims 1 to 3, comprising a first annealing at a first temperature for a first duration to form a first intermetallic compound of first texture and having a first phase, and a second annealing at a higher temperature than said first temperature to form a second intermetallic compound of first texture and having a second phase.

5. Process for manufacturing an intermetallic contact according to one of claims 1 to 4, comprising an annealing carried out at a temperature between 200°C and 320°C, with a preference for the range 240°C and 290°C, for a duration dependent on the thickness of Ni deposited, in order to form an $Ni_3InGaAs$ intermetallic compound.

6. Process for manufacturing an intermetallic contact according to claim 5, wherein the initial thickness of Ni being between a few nanometres and a few tens of nanometres, the annealing time varies between a few minutes and a few tens of minutes.

7. Manufacturing process according to either of claims 5 or 6, wherein said annealing carried out at a temperature between 200°C and 320°C, with a preference for the range 240°C and 290°C, is followed by an annealing, carried out at a temperature between 250°C and 550°C in order to modify the resistivity of said intermetallic contact formed.

8. Process according to either of claims 6 or 7, wherein said annealing carried out at a temperature between 200°C and 320°C, with a preference for the range 240°C and 290°C, is followed by an annealing carried out at a temperature between 250°C and 350°C in order to form an $Ni_3InGaAs$ compound.

9. Process for manufacturing an intermetallic contact according to one of claims 1 to 8, wherein the nomograms are produced by measuring the intermetallic compound thicknesses formed as a function of time.

10. Process for manufacturing an intermetallic contact according to claim 9, wherein the thickness measurements are performed by x-rays.

11. Process for manufacturing an intermetallic contact according to claim 9, wherein the thickness measurements are performed by ellipsometry.

12. Process for manufacturing an intermetallic contact according to one of claims 1 to 11, comprising the deposition of a protective layer on the surface of the localized deposition of Ni, prior to the annealing operation(s).

13. Process for manufacturing a transistor comprising the process for manufacturing an intermetallic contact according to one of claims 1 to 12.

14. Process for manufacturing a photonic component comprising the process for manufacturing an intermetallic contact according to one of claims 1 to 12.

**FIG.1**

**FIG.2**

**FIG.3**

FIG.4a

FIG.4b

**Simulation Ni 7 nm – Rampe 60°C/min**

FIG.5a

**Simulation Ni 7 nm – Rampe 300°C/min**

FIG.5b

FIG.5c

FIG.6a

**Simulation Ni 10 nm – Rampe 150°C/min**

FIG.6b

**Simulation Ni 10 nm – Rampe 300°C/min**

FIG.6c

**Simulation Ni 20 nm – Rampe 20°C/min**

FIG.7a

**Simulation Ni 20 nm – Rampe 35°C/min**

FIG.7b

**Simulation Ni 20 nm – Rampe 70°C/min**

FIG.7c

FIG.8a

Temps (s)

**FIG.8b**

Temps (s)

**FIG.8c**

FIG.9

EP 3 422 390 B1

FIG.10

FIG.11

FIG.12

FIG.13

FIG.14

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **S. H. KIM et al.** *IEDM,* 2010, 26.6
- **IVANA et al.** *J. Vac. Sci. Technol.,* 2013, vol. B 31, 012202
- **P. SHEKTER et al.** *J. Vac. Sci. Technol.,* 2013, vol. B 31, 031205
- **S. H. KIM et al.** *IEEE Trans. Electron. Devices,* 2013, vol. 60, 2512
- **E. GHEGIN et al.** *IEEE Silicon Nanoelectronics Workshop,* 2016, 214
- **S. ZHIOU et al.** J. Appl. Phys. 2016, vol. 120, 13530

- Phase formation between Ni thin films and GaAs substrate. **RABHI S et al.** SCRIPTA MATERIALIA. ELSEVIER, 22 Juillet 2017, vol. 141, 28-31
- Formation of Ni3inGaAs phase in Ni/InGaAs contact at low temperature. **PERRIN C et al.** APPLIED PHYSICS LETTERS. A I P PUBLISHING LLC, 26 Septembre 2016, vol. 109
- **J. S. SOLOMON ; S. R. SMITH.** *J. Vac. Sci. Technol.,* 1987, vol. A 5, 1809
- **DE H. F. CHUANG et al.** *J. Electron. Mater.,* 1995, vol. 24, 767
- **Y. ASHIZAWA et al.** *J. Electron. Mater.,* 1996, vol. 25, 715